(19) Europäisches Patentamt

European Patent Office

Office européen des brevets

(11) **EP 0 920 131 A2**

(12) **EUROPÄISCHE PATENTANMELDUNG**

(43) Veröffentlichungstag:
02.06.1999 Patentblatt 1999/22

(51) Int. Cl.$^6$: **H03H 19/00**

(21) Anmeldenummer: 98122682.2

(22) Anmeldetag: 30.11.1998

(84) Benannte Vertragsstaaten:
AT BE CH CY DE DK ES FI FR GB GR IE IT LI LU MC NL PT SE
Benannte Erstreckungsstaaten:
AL LT LV MK RO SI

(30) Priorität: 01.12.1997 DE 19753279

(71) Anmelder:
STMicroelectronics GmbH
85630 Grasbrunn (DE)

(72) Erfinder:
• Schambacher, Jörg
 81667 München (DE)
• Kirchlechner, Peter
 83104 Hohenthann (DE)
• Lübbe, Jürgen
 83553 Jacobneuharting (DE)

(74) Vertreter: Hirsch, Peter
Kıunker Schmitt-Nilson Hirsch
Winzererstrasse 106
80797 München (DE)

(54) **Elektrische Schaltung mit mindestens einem geschalteten Kondensator und Verfahren zum Betreiben dieser Schaltung**

(57) In einer integrierten Schaltung mit einem sogenannten "geschalteten" Kondensator ($C_S$) wird letzterer durch eine Parallelschaltung aus zwei komplementären Schalttransistoren (1, 2) mit zueinander komplementären Schaltimpulszügen geschaltet. Durch parasitäre Effekte bei diesem Schaltvorgang kommt es an dem geschalteten Kondensator zu störenden Offset-Spannungen. Um diese zu vermeiden, werden die Flanken des einen Schaltimpulszuges ($\phi n$) gegenüber den entsprechenden Flanken des komplementären Schaltimpulszuges ($\phi p$) zeitlich verschoben. Hierzu enthält ein Schaltimpulsgeber ein Verzögerungsglied, dem ein Stellsignal zugeführt wird, welches mit Hilfe einer konstanten Referenzspannung unter Verwendung einer Nachbildung derjenigen Schaltung gebildet wird, die den geschalteten Kondensator ($C_S$) enthält.

FIG.1a

FIG.1b

**Beschreibung**

Die Erfindung betrifft eine elektrische Schaltung mit mindestens einem sogenannten geschalteten Kondensator. Die Erfindung betrifft außerdem ein Verfahren zum Betreiben einer solchen elektrischen Schaltung.

Speziell geht es um eine elektrische Schaltung mit mindestens einem geschalteten Kondensator, der über einen Parallelkreis mit zwei elektronischen, komplementären Schaltern geschaltet wird, die von komplementären Schaltimpulsen angesteuert werden, mit einem Schaltimpulsgeber, der ein Grundtaktsignal empfängt und daraus einen ersten Schaltimpulszug sowie einen nahezu komplementären, zweiten Schaltimpulszug bildet. Außerdem geht es um ein Verfahren zum Betreiben einer solchen elektrischen Schaltung.

Es ist bekannt, in integrierten Schaltungen bestimmte Funktionen mit Hilfe von sogenannten geschalteten Kondensatoren (switched capacitors; SC) zu realisieren, beispielsweise die Funktion eines ohm'schen Widerstands. Bekanntlich errechnet sich die Impedanz eines Kondensators aus dem Reziprokwert des Produkts aus Frequenz und Kapazität. Dementsprechend werden zum Simulieren ohm'scher Widerstände integrierte Kondensatoren über Schalter angesteuert, so daß ein ständiger Umladevorgang am Kondensator stattfindet. Die Frequenz des Ansteuersignals ist auf die Kapazität des Kondensators so abgestimmt, daß die gewünschte Impedanz erreicht wird.

Durch Simulierung ohm'scher Widerstände mit Hilfe geschalteter Kondensatoren läßt sich eine beträchtliche Ersparnis bei der Chipbelegungsfläche erreichen.

Zum Schalten eines "geschalteten Kondensators" verwendet man üblicherweise einen Feldeffekttransistor mit isoliertem Gate (IGFET), insbesondere verwendet man zwei miteinander parallel geschaltete komplementäre Feldeffekttransistoren (CMOS-Feldeffekttransistoren).

Bei der vorliegenden Erfindung geht es um Probleme bei dem Ansteuern eines geschalteten Kondensators mit komplementären Transistorschaltern, die mit komplementären Schaltimpulszügen angesteuert werden.

Fig. 1a zeigt einen geschalteten Kondensator $C_S$ mit einem ersten Schalttransistor 1, der mit einem Schaltsignal $\phi n$ angesteuert wird, zu dem ein zweiter, zu dem ersten Schalttransistor komplementärer Schalttransistor geschaltet ist, der mit einem komplementären Schaltsignal $\phi p$ angesteuert wird. Durch die komplementäre Ansteuerung der komplementären Transistoren sind entweder beide Transistoren gleichzeitig geschlossen oder gleichzeitig geöffnet.

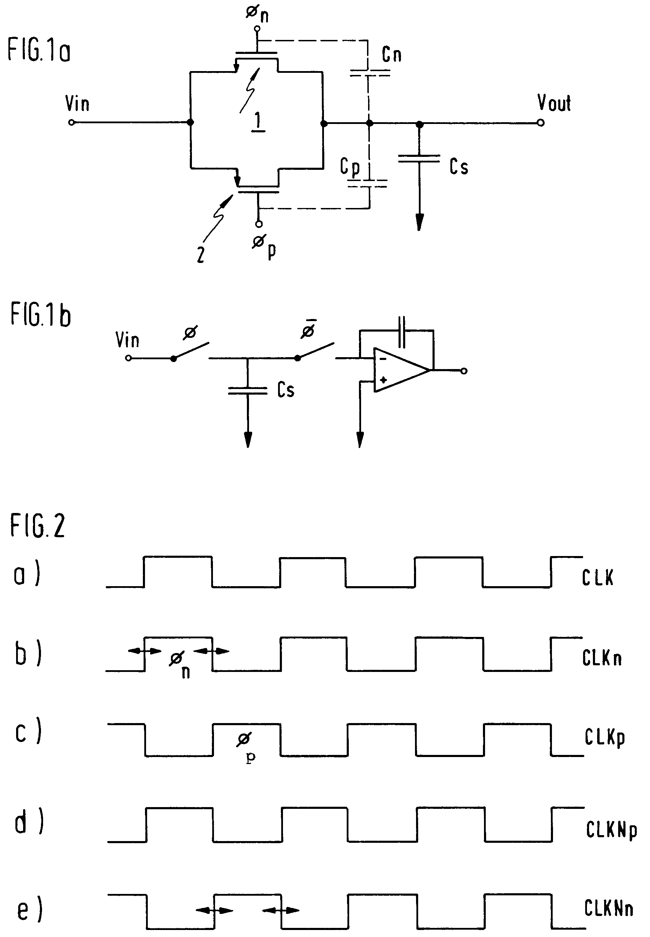

Fig. 1b zeigt eine schematische Skizze einer Schaltung innerhalb einer integrierten Schaltung mit einer geschalteten Kapazität $C_S$, der jeweils ein Transistorschalter vorgeschaltet und ein Transistorschalter nachgeschaltet ist. Der geschalteten Kapazität nachgeordnet ist ein Operationsverstärker. Die in Fig. 1a dargestellte Schaltung entspricht der Schaltkapazität $C_S$ mit dem dieser vorgeschalteten Schalter, der von dem Schaltimpulszug $\phi$ angesteuert wird, wobei $\phi$ in Fig. 1b die beiden Signale $\phi_n$ und $\phi_p$ in Fig. 1a beinhaltet. Der in Fig. 1b dargestellte Schalter, der von dem Signal $\phi$ angesteuert wird, kann in ähnlicher Weise ausgebildet sein wie die in Fig. 1a dargestellte Parallelschaltung von zwei komplementären MOS-Feldeffekttransistoren.

In Fig. 1a sind gestrichelt parasitäre Kapazitäten Cn und Cp angedeutet. Diese parasitären Kapazitäten werden gebildet durch die Gate-Source-Kapazität des ersten Schalttransistors 1 bzw. des zweiten Schalttransistors 2. Wenn diese beiden parasitären Kapazitäten Cn und Cp gleichen Wert haben und ein gleichzeitiges Sperren und gleichzeitiges Öffnen der Transistorschalter 1 und 2 erfolgt, lädt der Kondensator Cs bzw. entlädt dieser Kondensator in der vorbestimmten Weise. Allerdings ergibt sich eine Offset-Spannung an dem Kondensator $C_S$, wenn die beiden Kapazitäten Cn und Cp voneinander verschieden sind:

$$\Delta Q_{pn} = (Cp - Cn)\Delta U$$
$$= \Delta Cpn \cdot \Delta U$$

$$\Delta Cpn = 0 \ \} \ \Delta Q_{pn} = 0$$

(} bedeutet: daraus folgt)

Aus der obigen Gleichung ergibt sich eine Restladung für $C_S$ von 0, wenn Cp genau so groß ist wie Cn, ansonsten ergibt sich eine von 0 verschiedene Restladung. Der obige Einfluß der parasitären Kapazitäten Cn und Cp wird auch als "Taktdurchgriff" (clock feedthrough) bezeichnet.

Ein weiterer, den exakten Betrieb des geschalteten Kondensators beeinträchtigender Faktor ist der sogenannte Ladungstransfer (charge transfer), der dadurch entsteht, daß der Umschaltzeitpunkt beim Öffnen und Schließen der beiden Schalttransistoren 1 und 2 in Fig. 1 für die beiden Schalttransistoren differiert.

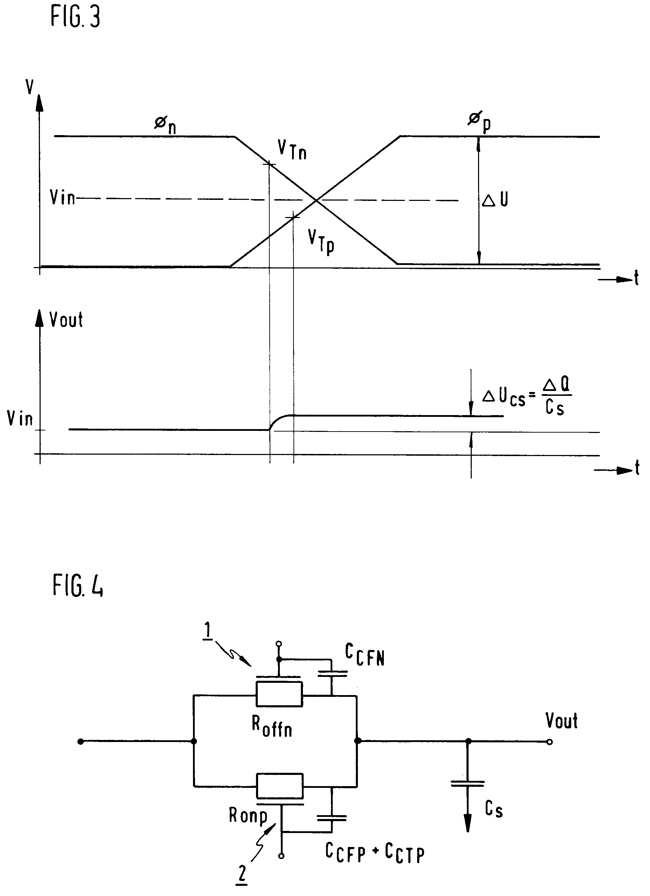

In Fig. 3 sind im oberen Teil die Signalverläufe für die Schaltimpulse $\phi n$ bzw. $\phi p$ dargestellt, wobei zu sehen ist, daß in der Praxis die Signalflanken nicht senkrecht zur Zeitachse, sondern schräg verlaufen. Im unteren Teil der Fig. 3 ist die Ausgangsspannung Vout der Schaltungsanordnung nach Fig. 1a dargestellt. Im Idealfall sollte nach dem Umschalten der beiden Schalttransistoren 1 und 2 die Ausgangsspannung Vout am Kondensator $C_S$ den vorherigen Wert behalten. Tatsächlich ergibt sich jedoch ein Versatz (Offset-Spannung) mit dem Wert $\Delta U_{cs} = \Delta Q/C_S$.

Bedingt ist diese Offsetspannung durch unterschiedliche Schaltschwellen der beiden Schalttransistoren 1 und 2 (bzw. bei einem CMOS-Feldeffekttransistor des n-Kanals und des p-Kanals).

Wie oben aus Fig. 3 ersichtlich ist, wird bei der Abfallflanke des Schaltimpulses $\phi$n der Schaltzeitpunkt entsprechend der Schwellenspannung $V_{Tn}$ früher erreicht als der Schaltzeitpunkt bei dem Schalttransistor 2, bei dem das Schaltsignal $\phi$p die Schwellenspannung $V_{Tp}$ relativ spät erreicht.

Fig. 4 zeigt die Schaltung nach Fig. 1b für den Zeitpunkt, der in Fig. 3 dargestellt ist. Zunächst schließt der Schalttransistor 1 im Verlauf der Rückflanke des Signals $\phi$n, so daß der Widerstand dieses Schalters Roffn sehr hoch ist (der Widerstand zwischen Drain und Source des Schalttransistors 1).

Da der untere Schalttransistor 2 noch nicht geschlossen ist, ist der Einschaltwiderstand Ronp (der Widerstand zwischen Drain und Source des Schalttransistors 2) noch viel kleiner als der Ausschaltwiderstand Roffn des ersten Schalttransistors 1.

Jetzt ergibt sich für die dann wirksamen parasitären Kapazitäten folgende Situation:

Zwischen dem Gate des Schalttransistors 1 und dem Ausgangsknoten der Schaltung befindet sich eine Kapazität $C_{CFN}$ (CF steht für "clock feed-through"). Zwischen dem Gate des unteren Schalttransistors 2 und dem Ausgangsknoten der Schaltung ergibt sich eine Kapazität von

$$C_{CFP} + C_{CTP}$$

(wobei CT für "charge transfer" steht).

Während in dem Kanal des Schalttransistors 1 keine Ladung mehr gespeichert ist, erfolgt keine Kompensation der in dem p-Kanal des Schalttransistors 2 gespeicherten Ladung. Hiermit errechnet sich die Restladung wie folgt:

$$\Delta Q = (C_{CT} + C_{CFP})V_{TN} - C_{CFN} \cdot V_{TN} \approx C_{CT} \cdot V_{TN}$$

Um die durch die obigen Vorgänge und Gegebenheiten der Schaltung entstehenden Offset-Spannungen zu vermeiden, schlägt die vorliegende Erfindung vor, die Flanken der Schaltimpulszüge so zu regeln, daß eine vollständige (wenn man von einer bleibenden Regelabweichung absieht) Kompensation der Offset-Spannung erfolgt.

Zu diesem Zweck schafft die Erfindung ein Verfahren zum Betreiben einer Schaltung mit einem geschalteten Kondensator, bei dem zumindest und bevorzugt von mindestens einem der komplementären Schaltimpulssignale (z.B. $\phi$n) die Vorderflanke und/oder die Rückflanke derart regelbar ist, daß sie nach Maßgabe der Ausgangsspannung der zueinander parallel liegenden Schalter (1, 2) gegenüber der zugehörigen Flanke des anderen der komplementären Schaltimpulssignale ($\phi$p) verschoben wird. Die elektronischen Schalter sind vorzugsweise komplementäre MOS-FETs.

Denkbar ist eine solche Flankenregelung in Form einer Änderung der Flankensteilheit. Dies ist aber möglicherweise schaltungstechnisch nur schwierig zu realisieren. Deshalb wird die zu regelnde Flanke zeitlich verschoben, und zwar in der Weise, daß beide Schalter praktisch gleichzeitig in den Sperrzustand gelangen.

Die Erfindung schafft außerdem eine elektrische Schaltung mit mindestens einem geschalteten Kondensator, der über einen Parallelkreis aus zwei elektronischen, komplementären Schaltern geschaltet wird von zwei komplementären Schaltimpulszügen, die von einem Schaltimpulsgeber aus einem Grundtaktsignal erzeugt werden. Zum Regeln der Vorderflanke und/oder Rückflanke zumindest des einen Schaltimpulszugs enthält die Schaltung:

- eine Regelschaltung, die die beiden Schaltungimpulszüge empfängt und unter Verwendung eines Bezugssignals ein Stellsignal liefert, und
- eine Verzögerungsschaltung innerhalb des Schaltimpulsgebers, die das Stellsignal empfängt und den ersten und/oder den zweiten Schaltimpulszug abhängig von dem Stellsignal verzögert.

In einer bevorzugten Ausgestaltung der Erfindung ist die Verzögerungsschaltung im Ausgangskreis für den ersten Schaltimpulszug angeordnet. Der zweite Schaltimpulszug bleibt dann unverändert so, wie er von dem Schaltimpulsgeber bereitgestellt wird, und nur der erste Schaltimpulszug wird relativ zu dem zweiten Schaltimpulszug verzögert.

Ein typisches Anwendungsbeispiel für geschaltete Kondensatoren sind Filterschaltungen. Eine solche Filterschaltung mit beispielsweise einem Operationsverstärker, in dessen Rückkopplungskreis ein Kondensator und in dessen Eingangskreis ein durch einen geschalteten Kondensator simulierter Widerstand liegt, wird erfindungsgemäß in Form einer "Nachbildung" als Regelschaltung eingesetzt. Je nachdem, ob das durch diese "Nachbildung" gewonnene Ausgangssignal größer oder Kleiner als ein Referenzsignal ist, werden die Flanken des einen Schaltimpulszugs mehr oder weniger stark verzögert, mit dem Ziel, daß beide Schalttransistoren gleichzeitig sperren.

Im folgenden werden Ausführungsbeispiele der Erfindung anhand der Zeichnungen näher erläutert. Es zeigen:

Fig. 1a eine Schaltungsskizze mit einem geschalteten Kondensator und einem diesem vorgeschalteten elektronischen Schalter, bestehend aus zwei komplementären Schalttransistoren,

**Fig. 1b** eine Skizze einer Filterschaltung, in deren Eingangskreis ein ohm'scher Widerstand durch einen geschalteten Kondensator mit vor- und nachgeschaltetem elektronischen Schalter simuliert wird;

**Fig. 2** Impulsdiagramme für Schaltimpulszüge, die die beiden Schalttransistoren 1 und 2 in Fig. 1a und zwei dazu komplementäre Schalttransistoren ansteuern;

**Fig. 3** ein Wellenformdiagramm zum Erläutern der Probleme der bekannten Schaltungen mit komplementär angesteuerten Schalttransistoren;

**Fig. 4** eine Ersatzschaltung für den Schalter nach Fig. 1a im Umschaltzeitpunkt;

**Fig. 5** ein Wellenformdiagramm ähnlich demjenigen in Fig. 3, jedoch für erfindungsgemäß gesteuerte Schaltimpulse;

**Fig. 6** ein Blockdiagramm eines Schaltimpulsgebers gemäß der Erfindung; und

**Fig. 7** eine Nachbildung einer elektrischen Schaltung, die zur Gewinnung eines Stellsignals für zwei Verzögerungsglieder in der Schaltung nach Fig. 6 dient.

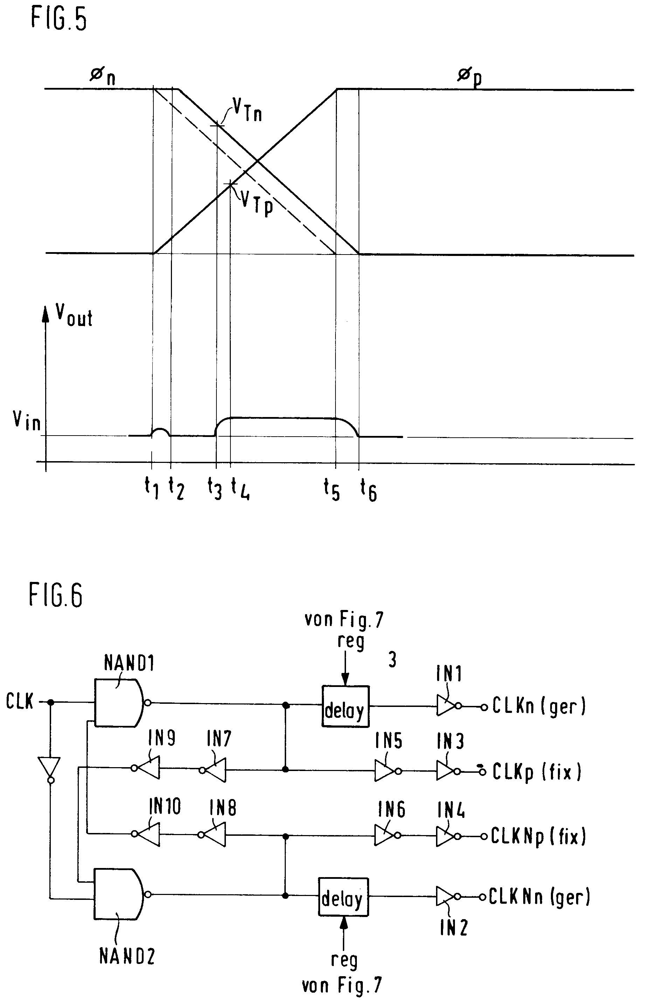

Die Arbeits- und Funktionsweise der erfindungsgemäßen Schaltung und des erfindungsgemäßen Verfahrens sollen zunächst anhand der Fig. 5 erläutert werden.

Wie man durch Vergleich mit der Fig. 3 sieht, ist die Abfallflanke des Schaltimpulses $\phi n$ zeitlich verzögert gegenüber der Anstiegsflanke des Schaltimpulses $\phi p$. Dies wird durch eine unten noch näher zu erläuternde Regelung der Flanke des Schaltimpulszugs $\phi n$ erreicht. Die ungeregelte, nicht verzögerte Flanke des Schaltimpulses $\phi n$ ist durch eine gestrichelte Linie angedeutet.

Wie aus dem Wellenformdiagramm in Fig. 5 ersichtlich ist, erfolgt zunächst im Zeitpunkt t1 die Pegeländerung des Schaltimpulses $\phi p$. Wie unten in Fig. 5 zu sehen ist, steigt Vout gegenüber Vin an, aber nur solange, bis der Schaltimpuls $\phi n$ abzufallen beginnt. Die beiden Schaltschwellen $V_{Tn}$ und $V_{Tp}$ werden kurz nacheinander zu dem Zeitpunkt t3 bzw. t4 erreicht. In der Zeitspanne zwischen t3 und t4 ist der n-Kanal bzw. der Schalttransistor 1 in Fig. 1a gesperrt, für den p-Kanal bzw. den Schalttransistor 2 erfolgt keine Kompensation. Nach dem Zeitpunkt t4 ist dann auch der p-Kanal gesperrt, es erfolgt lediglich eine Kompensation des CF-Anteils. Zwischen den Zeitpunkten t5 und t6 erfolgt dann schließlich die Ladungskompensation für den p-Kanal, weil die Flanke des Signals $\phi n$ gegenüber derjenigen des Signals $\phi p$ verzögert ist.

Um den oben erläuterten Betrieb zu erreichen, wird der in Fig. 6 dargestellte Schaltimpulsgeber verwendet.

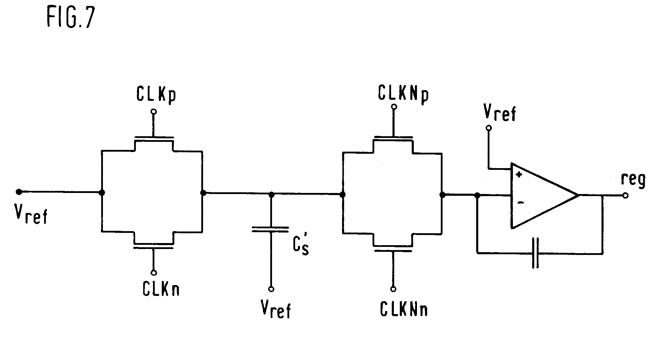

Ein Grundtaktsignal CLK wird auf ein NAND-Gatter NAND1 gegeben, gleichzeitig wird das invertierte Signal von CLK auf ein NAND-Gatter NAND2 gegeben. Das Ausgangssignal von NAND 1 gelangt über ein Verzögerungsglied 3 und einen Negator IN1 an einen Taktausgang für das Signal CLKn. Wie weiter unten noch erläutert wird, ist dieses Taktsignal oder Schaltimpulssignal geregelt durch ein Stellsignal "reg", welches von der unten noch erläuterten Schaltung gemäß Fig. 7 erzeugt wird.

Das Ausgangssignal von NAND1 gelangt außerdem über zwei Negatoren IN7 und IN9 an einen zweiten Eingang von NAND2. Der zweite Eingang von NAND1 empfängt außerdem das Ausgangssignal von NAND2 über zwei Negatoren IN8 und IN10.

Das zu dem Signal CLKn komplementäre oder negierte Signal wird als Signal CLKNn als geregeltes Schaltimpulssignal am Ausgang eines Negators IN2 erhalten, dem ein weiteres Verzögerungsglied 4 vorgeschaltet ist, welches seinerseits an den Ausgang von NAND2 angeschlossen ist.

Über eine Reihenschaltung aus zwei Negatoren IN3 und IN5 wird ein ungeregeltes Schaltimpulssignal CLKp aus dem Ausgangssignal von NAND1 gebildet. Aus dem Ausgangssignal von NAND2 wird über zwei Negatoren IN6 und IN4 ein ungeregeltes Taktsignal oder Schaltimpulssignal CLKNp gebildet.

Fig. 2 zeigt die in Fig. 6 dargestellten Eingangs- und Ausgangssignale, wobei insbesondere ersichtlich ist, daß die Rückflanke des Signal CLKn gegenüber CLKp geregelt ist und CLKNn gegenüber CLKNp geregelt ist.

Fig. 7 zeigt die Skizze einer Schaltung, mit der das in Fig. 6 als Eingangssignal für die Verzögerungsglieder 3 und 4 dargestellte Stellsignal "reg" gewonnen wird. Die in Fig. 7 dargestellte Schaltung ist im Prinzip so aufgebaut wie die elektrische Schaltung nach Fig. 1b, in der der Schaltungskondensator Cs im Eingangskreis eines Operationsverstärkers der Filterschaltung zu schalten ist. Die in Fig. 7 dargestellte Schaltung enthält die beiden Schalter im Eingangskreis bzw. im Ausgangskreis des Kondensators $C_S$ und den Operationsverstärker, wobei anstelle der Eingangsspannung Vin in Fig. 1b eine feste Referenzspannung Vref eingangsseitig angelegt ist.

Die Ausgangssignale des Schaltimpulsgebers nach Fig. 6 werden in der in Fig. 7 dargestellten Weise an die Schalttransistoren gegeben. Hierdurch wird an dem Ausgang der Schaltung nach Fig. 7 ein Stellsignal für die beiden Verzögerungsschaltungen 3 und 4 in Fig. 6 erhalten. Steigt das Signal "reg" an, so wird der Schaltimpuls CLKn entsprechend stark verzögert, mit der Folge, daß hierdurch die Amplitude des Stellsignals "reg" sinkt und damit auch die Verzögerung kleiner wird, die das Verzögerungsglied 3 in Fig. 6 macht. Entsprechendes gilt für das negierte Signal CLKNn.

Durch die erfindungsgemäße Flankenregelung des Schaltimpulszugs für das Schaltimpulssignal CLKn bzw. CLKNn wird die Entstehung von Offset-Spannungen an dem geschalteten Kondensator vermieden.

In Abwandlung der oben beschriebenen Ausführungsform könnte alternativ auch natürlich das Signal CLKp bzw. CLKNp flankengeregelt werden.

**Patentansprüche**

1. Verfahren zum Betreiben einer elektrischen Schaltung, die einen geschalteten Kondensator enthält, der mittels komplementärer elektronischer Schalter (1, 2) geschaltet wird, die elektrisch parallel zueinander liegen und mit komplementären Schaltimpulssignalen ($\phi$n, $\phi$p; CLKn, CLKp) angesteuert werden,
   **dadurch gekennzeichnet,**
   daß zumindest und bevorzugt von mindestens einem der komplementären Schaltimpulssignale (z.B. $\phi$n) die Vorderflanke und/oder die Rückflanke derart regelbar ist, daß sie nach Maßgabe der Ausgangsspannung der zueinander parallel liegenden Schalter gegenüber der zugehörigen Flanke des anderen der komplementären Schaltimpulssignale ($\phi$p) verschoben wird.

2. Verfahren nach Anspruch 1,
   **dadurch gekennzeichnet,**
   daß die elektronischen Schalter komplementäre MOS-FETs sind.

3. Verfahren nach Anspruch 1 oder 2,
   **dadurch gekennzeichnet,**
   daß die Flanken zeitlich verschoben werden.

4. Verfahren nach einem der Ansprüche 1 bis 3,
   **dadurch gekennzeichnet,**
   daß die Flanke derart verschoben wird, daß beide Schalter im wesentlichen gleichzeitig in den Sperrzustand gelangen.

5. Elektrische Schaltung mit mindestens einem geschalteten Kondensator, der über einen Parallelkreis aus zwei elektronischen, komplementären Schaltern (1, 2) geschaltet wird, die von komplementären Schaltimpulsen ($\phi$n, $\phi$p) angesteuert werden, mit einem Schaltimpulsgeber, der ein Grundtaktsignal (CLK) empfängt und daraus einen ersten Schaltimpulszug (CLKn) sowie einen dazu komplementären, zweiten Schaltimpulszug (CLKp) bildet,
   **gekennzeichnet durch**

   - eine Regelschaltung (Fig. 7), die die beiden Schaltimpulszüge empfängt und unter Verwendung eines Bezugssignals (Vref) ein Stellsignal (reg) liefert, und
   - eine Verzögerungsschaltung (3, 4) innerhalb des Schaltimpulsgebers, die das Stellsignal empfängt und den ersten und/oder den zweiten Schaltimpulszug abhängig von dem Stellsignal (reg) verzögert.

6. Schaltung nach Anspruch 5,
   **dadurch gekennzeichnet,**
   daß die Verzögerungsschaltung in dem Ausgangskreis für den ersten Schaltimpulszug angeordnet ist.

7. Schaltung nach Anspruch 5 oder 6,
   **dadurch gekennzeichnet,**
   daß die Regelschaltung als Nachbildung der den geschalteten Kondenstor ($C_S$) enthaltenden elektrischen Schaltung ausgebildet ist.

FIG.1a

FIG.1b

FIG.2

a) CLK

b) CLKn

c) CLKp

d) CLKNp

e) CLKNn

FIG. 3

FIG. 4

FIG.5

$\emptyset_n$

$\emptyset_p$

$V_{Tn}$

$V_{Tp}$

$V_{out}$

$V_{in}$

$t_1$ $t_2$   $t_3$ $t_4$   $t_5$ $t_6$

FIG.6

von Fig.7
reg
3

NAND1

IN1

CLK

delay

CLKn (ger)

IN9    IN7

IN5    IN3

CLKp (fix)

IN10    IN8

IN6    IN4

CLKNp (fix)

NAND2

delay

CLKNn (ger)

IN2

reg
von Fig.7

FIG.7